# EUROPEAN PATENT APPLICATION

(11) **EP 4 576 960 A2**
(43) Date of publication of application: **25.06.2025**
(21) Application number: 24214986.2
(22) Date of filing: 23.11.2024
(51) Int. Cl.: H05K 7/14, H05K 7/20

(54) **INTEGRATED RACK POWER-COOLING DELIVERY DEVICE**

(30) Priority: 30.11.2023 US 202363604461 P; 04.11.2024 US 202418936730
(71) Applicant: Vertiv Corporation, Westerville, OH 43082 (US)
(72) Inventor: ALDAG, Philip R., Westerville, 43082 (US); FERGUSON, Kevin R., Westerville, 43082 (US)
(74) Representative: Bryn-Jacobsen, Caelia

(57) **Abstract**

A power distribution system may include a power distribution sub-system including power distribution circuitry to provide power from an input source to loads through outlets; a liquid cooling sub-system to provide active cooling to at least some of the loads, where the liquid cooling sub-system includes one or more manifolds providing one or more supply nozzles and one or more return nozzles for directing fluid for the active cooling; and one or more housings configured to enclose the power distribution sub-system and the liquid cooling sub-system, where the one or more housings further provide thermal coupling between the power distribution sub-system and the liquid cooling sub-system for at least partial cooling of at the power distribution sub-system. The system may further capture load diagnostic data associated with the loads and classify the loads into two or more classes based on the load diagnostic data.

## Description

### CROSS-REFERENCE TO RELATED APPLICATION

The present application claims the benefit under 35 U.S.C. § 119(e) of U.S. Provisional Application Serial Number 63/604,461, filed November 30, 2023, entitled INTEGRATED RACK POWER-COOLING DELIVERY DEVICE, naming Philip R. Aldag and Kevin R. Ferguson as inventors.

### TECHNICAL FIELD

The present disclosure relates generally to power distribution systems and, more particularly, to power distribution systems incorporating liquid cooling and profile monitoring.

### BACKGROUND

High-density (HD) servers requiring liquid cooling present practical challenges when installed in server racks. For example, HD servers may also produce air-side heat losses of 15-20% of the heat load or higher even with liquid cooling. The zero-U area in the back of server racks must also accommodate a variety of components including power distribution systems, cabling (e.g., power cabling, networking cabling, or the like), and the liquid cooling manifolds with associated piping. As a result, the back of server racks may become highly congested and/or difficult to access. In such server racks, server performance and/or reliability may become compromised due to restricted heat-rejection airflow, heat-stressed power distribution circuitry, and/or hindered physical infrastructure maintenance. There is therefore a need to develop systems and methods to address the above deficiencies.

### SUMMARY

In examples, the techniques described herein relate to a power distribution system including a power distribution sub-system including power distribution circuitry configured to provide power from an input source to a plurality of loads through a plurality of outlets, where each of the plurality of outlets is configured to provide an electrical connection to any connected one of the plurality of loads; a liquid cooling sub-system configured to provide active cooling to at least some of the plurality of loads, where the liquid cooling sub-system includes one or more manifolds providing one or more supply nozzles and one or more return nozzles for directing fluid for the active cooling; and one or more housings configured to at least partially enclose the power distribution sub-system and the liquid cooling sub-system, where the one or more housings further provide thermal coupling between the power distribution sub-system and the liquid cooling sub-system for at least partial cooling of at least a portion of the power distribution sub-system.

In examples, the techniques described herein relate to a power distribution system, where the one or more housings include a single housing to at least partially enclose the power distribution sub-system and the liquid cooling sub-system.

In examples, the techniques described herein relate to a power distribution system, where the one or more housings include a first housing to at least partially enclose the liquid cooling sub-system; and a second housing to at least partially enclose the power distribution sub-system, where the first housing and the second housing are thermally coupled.

In examples, the techniques described herein relate to a power distribution system, further including one or more hinges to provide access to a thermal interface material providing the thermal coupling through rotation of at least of the first housing or the second housing.

In examples, the techniques described herein relate to a power distribution system, further including one or more controllers, where each of the plurality of outlets is coupled to at least one of the one or more controllers, where a respective one of the one or more controllers includes one or more processors configured to execute program instructions stored on a memory device, where the program instructions are configured to cause the one or more processors to receive load diagnostic data for any loads connected to any of the plurality of outlets; and classify the plurality of loads connected to at least one of the plurality of outlets into two or more classes based on the load diagnostic data.

In examples, the techniques described herein relate to a power distribution system, where the load diagnostic data for a respective load of the plurality of loads includes at least one of a temperature of the respective load, a temperature of fluid exiting a respective supply nozzle of the one or more supply nozzles, a temperature of fluid exiting any of the one or more manifolds, a temperature of fluid entering a respective return nozzle of the one or more return nozzles, a temperature of fluid exiting any of the one or more manifolds, an ambient temperature of the power distribution system, an ambient temperature of the respective load, a die temperature associated with a processor of the respective load, utilization data of at least one of a central processing unit or a graphical processing unit of the respective load, current drawn by the respective load or a voltage drawn by the respective load.

In examples, the techniques described herein relate to a power distribution system, where the two or more classes include one or more normal classes associated with one or more acceptable operational conditions, where the two or more classes further include one or more atypical classes associated with one or more atypical operational conditions.

In examples, the techniques described herein relate to a power distribution system, where the two or more classes include a binary set of classes, where the one or more normal classes include a single normal class, where the one or more atypical classes include a single atypical class.

In examples, the techniques described herein relate to a power distribution system, where the two or more classes include two or more sets of classes, where each of the two or more sets of classes corresponds to a different load type, where each of the two or more sets of classes includes at least one of the one or more normal classes and at least one of the one or more atypical classes.

In examples, the techniques described herein relate to a power distribution system, where the one or more controllers are further configured to execute a subset of the program instructions causing the one or more controllers to generate one or more alert signals when at least one of the plurality of loads is classified as one of the one or more atypical classes.

In examples, the techniques described herein relate to a power distribution system, where the one or more controllers are further configured to execute a subset of the program instructions causing the one or more controllers to disconnect power to at least one of the plurality of loads when classified as one of the one or more atypical classes.

In examples, the techniques described herein relate to a power distribution system, where the one or more controllers include one or more first controllers configured to be communicatively coupled to the plurality of outlets, where the one or more first controllers are configured to execute a subset of the program instructions causing the one or more first controllers to classify the plurality of loads into the two or more classes using a machine learning model; and one or more second controllers configured to be communicatively coupled with the one or more first controllers, where the one or more second controllers are configured to execute a subset of the program instructions causing the one or more second controllers to train the machine learning model using training data including labeled load diagnostic data associated with the two or more classes.

In examples, the techniques described herein relate to a power distribution system, where the one or more first controllers and the one or more second controllers are located within the one or more housings.

In examples, the techniques described herein relate to a power distribution system, where at least one of the one or more first controllers or the one or more second controllers are located external to the one or more housings.

In examples, the techniques described herein relate to a power distribution system, where the one or more first controllers include one or more power output modules (POMs), where the one or more second controllers include one or more interchangeable monitoring devices (IMDs).

In examples, the techniques described herein relate to a power distribution system, where the one or more first controllers utilize embedded memory, where the one or more second controllers utilize external memory.

In examples, the techniques described herein relate to a power distribution system, where at least some of the labeled load diagnostic data is associated with historical load diagnostic data.

In examples, the techniques described herein relate to a power distribution system, where historical load diagnostic data is provided by at least one of the power distribution system, one or more additional power distribution systems, known historical failures of the plurality of loads, or a data lake.

In examples, the techniques described herein relate to a power distribution system, where the one or more controllers are further configured to execute a subset of the program instructions causing the one or more controllers to display information associated with at least one of the plurality of loads on a display device based on an associated classification based on the load diagnostic data.

In examples, the techniques described herein relate to a power distribution method including capturing, with a power distribution system, load diagnostic data for a plurality of loads connected to a plurality of outlets to receive power from an input power source connected to the plurality of outlets, where the power distribution system includes a liquid cooling sub-system configured to provide active cooling to at least some of the plurality of loads, where the liquid cooling sub-system includes one or more manifolds providing one or more supply nozzles and one or more return nozzles for directing fluid for the active cooling; classifying the plurality of loads connected to at least one of the plurality of outlets into two or more classes based on the load diagnostic data, where the two or more classes include one or more normal classes associated with one or more acceptable operational conditions, where the two or more classes further include one or more atypical classes associated with one or more atypical operational conditions; and when a particular load of the plurality of loads is classified as one of the one or more atypical classes, performing at least one of generating one or more alert signals; or disconnecting power to the particular load.

It is to be understood that both the foregoing general description and the following detailed description are exemplary and explanatory only and are not necessarily restrictive of the invention as claimed. The accompanying drawings, which are incorporated in and constitute a part of the specification, illustrate examples of the invention and together with the general description, serve to explain the principles of the invention.

### BRIEF DESCRIPTION OF DRAWINGS

The numerous advantages of the disclosure may be better understood by those skilled in the art by reference to the accompanying figures.
FIG. 1A is a block diagram illustrating a power distribution system, in accordance with one or more examples of the present disclosure.
FIG. 1B is a simplified schematic diagram of a power distribution system with a liquid-cooling (LC) sub-system thermally bonded to the power distribution sub-system, in accordance with one or more examples of the present disclosure.
FIG. 1C is a block diagram view of a power input module (PIM), in accordance with one or more examples of the present disclosure.
FIG. 1D is a block diagram view of a power output module (POM), in accordance with one or more examples of the present disclosure.
FIG. 1E is a block diagram view of an interchangeable monitoring device (IMD), in accordance with one or more examples of the present disclosure.
FIG. 2 is a flow diagram illustrating steps performed in a method for classifying loads, in accordance with one or more examples of the present disclosure.
FIG. 3 is a flow diagram depicting classification using a machine learning model, in accordance with one or more examples of the present disclosure.

### DETAILED DESCRIPTION

Reference will now be made in detail to the subject matter disclosed, which is illustrated in the accompanying drawings. The present disclosure has been particularly shown and described with respect to certain examples and specific features thereof. The examples set forth herein are taken to be illustrative rather than limiting. It should be readily apparent to those of ordinary skill in the art that various changes and modifications in form and detail may be made without departing from the scope of the disclosure.

Examples of the present disclosure are directed to systems and methods providing high-capacity power management with integrated liquid cooling for connected loads. Additional examples of the present disclosure are directed to systems and methods providing monitoring and classification of an operational condition of a load and/or an associated liquid cooling system based at least in part on environmental data associated with the load, the liquid cooling system, or ambient conditions. For example, load operational condition monitoring and classification may be performed using a machine learning model that accepts load diagnostic data as inputs, where the load diagnostic data includes at least temperature data associated with the load directly or temperature data associated with a liquid cooling sub-system.

In examples, a power distribution system may include power distribution circuitry configured to distribute power to loads through a set of outlets and may further include a liquid cooling (LC) system providing dedicated liquid cooling pipelines for loads connected to at least some of the outlets. The power distribution circuitry and the LC system may be provided in a common housing or in separate housings that are thermally coupled to promote heat transfer. Further, the liquid cooling pipelines may be physically located near the associated outlet and associated power distribution components (e.g., circuit breakers, or the like), which may provide both unambiguous per-load electrical and thermal connections as well as provide cooling of the power distribution components to promote efficient operation of both the load and the power distribution circuitry.

The power distribution system may further include environmental monitoring circuitry to generate and/or ports to accept load diagnostic data, which may include including information such as, but not limited to, temperature, humidity, or moisture of the loads or the server racks. The power distribution system may then include one or more controllers configured to predict and/or classify the operational conditions (e.g., states) of the connected loads based on the load diagnostic data using machine learning techniques. For example, the power distribution system may classify operational conditions of loads and/or an associated liquid cooling system into one or more normal classes associated with acceptable operating conditions and one or more atypical classes associated with failure or pre-failure conditions. In this way, loads in a failure condition, pre-failure condition, or compromised operating condition may be quickly identified and serviced.

The systems and methods disclosed herein may provide any number of classifications or sub-classifications of the loads (and an associated liquid cooling system) based on the load diagnostic data. In some examples, loads are classified using a binary-class classification system including a single normal class and a single atypical class. Such a configuration may be well suited for, but not limited to, identifying atypical behavior is desired. In some examples, load signals are classified using a multi-class classification system including a single normal class and multiple atypical classes. Such a configuration may be well suited for, but not limited to, discriminating between different atypical classes. For instance, different atypical classes may be associated with different failure mechanisms and/or different pre-failure conditions.

Additional examples of the present disclosure are further directed to generating one or more alert signals (e.g., lights, sounds, interrupts, maintenance requests, or the like) when load signals in an atypical class are identified. It is contemplated that the systems and methods disclosed herein may provide predictive failure analysis for connected loads. For example, the systems and methods disclosed herein may identify when a connected load is operating in an atypical manner based on the power signal to that load. Associated alerts may signal for various actions including, but not limited to, user intervention, disconnection of the load (either manually by a user or automatically based on the classification), replacement of the load, repair of the load, or maintenance of the load.

The systems and methods disclosed herein may provide numerous benefits for the operation and monitoring of liquid-cooled loads. The proximity of liquid cooling manifolds and power distribution systems provides an opportunity for improving server performance and/or health monitoring. For example, integrating power distribution circuitry with liquid cooling manifolds may efficiently utilize space, promote organization of power and cooling components, and enable cooling of the power distribution circuitry. As another example, integrating power distribution circuitry with liquid cooling manifolds conveniently allows for the collection of load-specific environmental data for monitoring and classification of operational conditions.

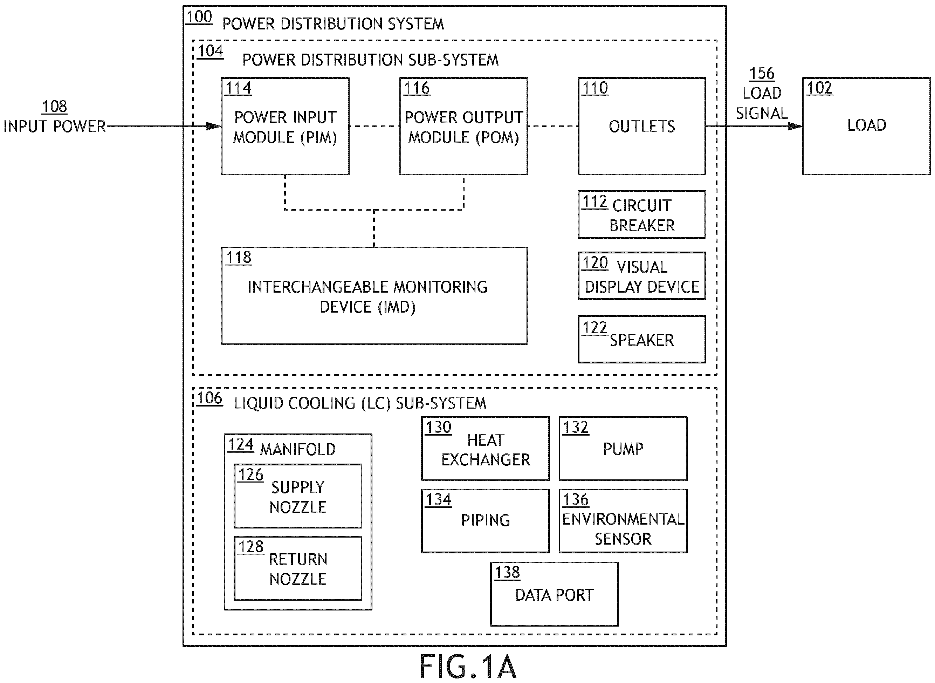

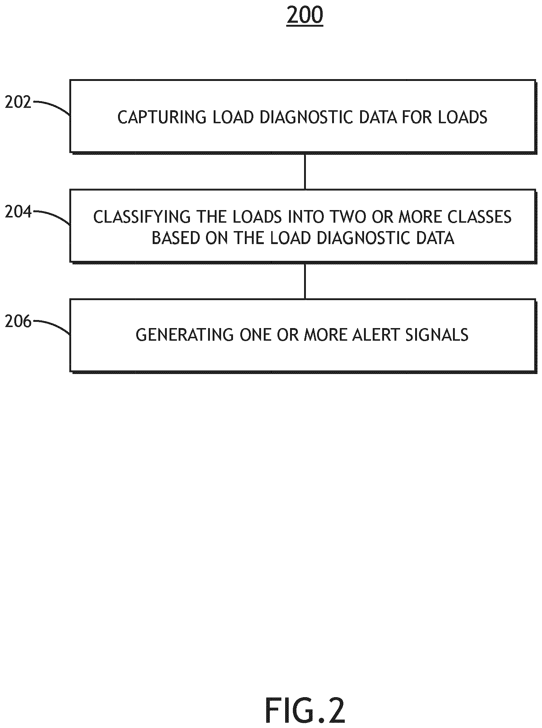

Referring now to FIGS. 1A-3, systems and methods for power distribution with integrated liquid cooling and temperature-based profiling are described in greater detail, in accordance with one or more examples of the present disclosure. In particular, FIGS. 1A-1E depict a power distribution system 100 suitable for distributing power to various loads 102, while FIGS. 2-3 depict process steps for classifying the loads 102 based on at least environmental data.

FIG. 1A is a block diagram illustrating a power distribution system 100, in accordance with one or more examples of the present disclosure. The power distribution system 100 may be, but is not required to be, characterized as a power distribution unit (PDU).

In examples, the power distribution system 100 includes a power distribution sub-system 104 and an LC sub-system 106. The power distribution sub-system 104 may include various electrical components to selectively distribute input power 108 to any number of loads 102 connected to any number of outlets 110 such as, but not limited to, transistors, relays, amplifiers, voltage converters, rectifiers, alternating current (AC) to direct current (DC) converters, DC to AC converters, DC to DC converters, or the like. The power distribution sub-system 104 may further include one or more controllers to direct and/or control (e.g., via control signals) such components to selectively distribute the input power 108 to the various outlets 110 and thus the connected loads 102. The outlets 110 may include plugs or other receptacles configured to provide electrical connections to various loads 102. The power distribution sub-system 104 may further include circuit breakers 112 or other electrical components associated with the outlets 110.

The various components of the power distribution sub-system 104 may be, but are not required to be, divided into various modules providing discrete functions either physically or functionally. For example, as illustrated in FIG. 1A, the power distribution sub-system 104 may include a power input module (PIM) 114 configured to accept input power 108 from one or more input sources (not shown) and at least one power output module (POM) 116 coupled to the outlets 110. A particular POM 116 may be connected to and may control the distribution of power to any number of outlets 110. Further, the power distribution system 100 may include any number of POMs 116 and associated outlets 110. Put another way, the outlets 110 may be distributed between any number of POMs 116. The power distribution system 100 may thus selectively distribute received input power 108 to any loads 102 connected to corresponding outlets 110 via the combined operation of the PIM 114 and corresponding POMs 116.

In examples, the power distribution system 100 further includes at least one interchangeable monitoring device (IMD) 118, which may be communicatively coupled with the PIM 114 and the one or more POMs 116. The IMD 118 may be, but is not required to be, interchangeable or replaceable. In this way, the acronym IMD is thus merely illustrative and should not be interpreted as limiting the scope of the present disclosure. An IMD 118 may receive data from and/or direct (e.g., via control signals) the PIM 114 and various POMs 116. For convenience, FIG. 1A depicts a power distribution system 100 having a single PIM 114, a single POM 116 connected to multiple outlets 110, and a single IMD 118. However, it is to be understood that this is also merely illustrative and should not be interpreted as limiting on the scope of the present disclosure. A power distribution system 100 may generally have any number of PIMs 114, POMs 116, or IMDs 118.

The power distribution system 100 may further include one or more components to provide visual and/or audio signals to a user. Such components may be suitable for alerting a user to a status of one or more connected loads 102 (or associated liquid cooling components) such as, but not limited to, an indication of when a load 102 is classified into an atypical class or any other alert condition.

For example, the power distribution system 100 may include one or more visual display devices 120. In some examples, the one or more visual display devices 120 include a display screen, which may provide any combination of text or graphical information. Further, a backlight or displayed background on a display screen may flash or show a selected color to provide additional information or alerts.

In some examples, the one or more visual display devices 120 include one or more light emitting diodes (LEDs), which may provide information based on color brightness, flashing, or the like. In some cases, the power distribution system 100 includes one or more LEDs associated with each outlet 110 (or at least one outlet 110) to provide separate visual indications for the associated loads 102. As another example, the power distribution system 100 may include one or more speakers 122 to provide audio signals such as, but not limited to, sounds or spoken text.

The LC sub-system 106 may include any components or combination of components suitable for providing active liquid cooling of one or more loads 102 connected to outlets 110. In examples, the LC sub-system 106 includes one or more manifolds 124 to accept a fluid (e.g., coolant) and direct the fluid through various pathways for cooling the various loads 102. For example, the one or more manifolds 124 may provide various supply nozzles 126 and return nozzles 128. In this way, fluid may be directed from the supply nozzles 126 to one or more loads 102 through piping to provide active cooling and then returned through the return nozzles 128 to form one or more cooling loops. The LC sub-system 106 may further include a heat exchanger 130 to control a temperature of the fluid (e.g., maintain the temperature of the fluid when heated by one or more loads 102 via the cooling loops. The LC sub-system 106 may further include one or more pumps 132 and/or piping 134 to circulate the fluid.

The LC sub-system 106 may further include one or more environmental sensors 136 configured to generate load diagnostic data and/or one or more data ports 138 to receive load diagnostic data associated with any of the loads 102. For example, the load diagnostic data may include data collected by environmental sensors 136 within a housing of the power distribution system 100 such as, but not limited to, a temperature associated with a supply nozzle 126 or a supply of the manifold 124 as a whole (e.g., a supply temperature), a temperature associated with a return nozzle 128 or a return of the manifold 124 as a whole (e.g., a return temperature), or ambient conditions near the power distribution system 100 (e.g., temperature, humidity, moisture, or the like). As another example, load diagnostic data may include data received by data ports 138 from external sources such as, but not limited to, a temperature of a load 102 (e.g., a graphical processing unit (GPU) temperature, a central processing unit (CPU) temperature, a chassis temperature, a die temperature, or the like), ambient conditions near a load 102 (e.g., temperature, humidity, moisture, or the like), or utilization data (e.g., utilization data of a CPU, a GPU or the like from a load 102).

The LC sub-system 106 and the power distribution sub-system 104 may be physically connected or housed in any suitable arrangement. In some examples, the LC sub-system 106 and the power distribution sub-system 104 are at least partially enclosed by a single housing. In some examples, the LC sub-system 106 and the power distribution sub-system 104 are at least partially enclosed by separate housings but may be physically attached and in some cases thermally bonded to provide efficient thermal transfer between the two. More generally, the power distribution system 100 may include one or more housings to at least partially enclose any portions of the power distribution sub-system 104 and/or the LC sub-system 106.

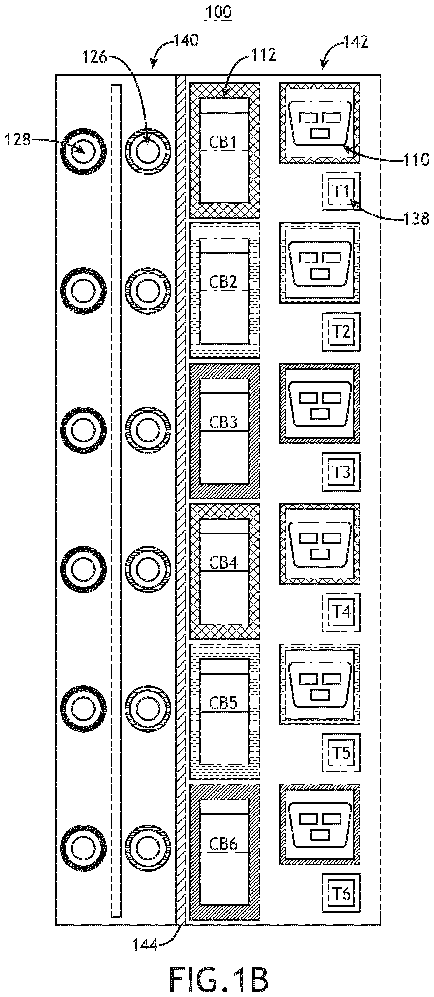

FIG. 1B is a simplified schematic diagram of a power distribution system 100 with a LC sub-system 106 thermally bonded to the power distribution sub-system 104, in accordance with one or more examples of the present disclosure.

The LC sub-system 106 may provide cooling of any number of loads 102 using any arrangement of components. For example, the LC sub-system 106 may include a dedicated supply nozzle 126 and/or a dedicated return nozzle 128 for one or more of the outlets 110.

FIG. 1B depicts a particular non-limiting configuration in which electronic and cooling components for each outlet 110 are physically grouped. For example, the LC sub-system 106 in this configuration includes a supply nozzle 126 and a return nozzle 128 dedicated to each outlet 110. Further, electronic components such as, but not limited to, the circuit breakers 112 and data ports 138 are also physically grouped by the corresponding outlets 110.

It is contemplated herein that physically grouping electronic and LC components for each outlet 110 may provide numerous benefits for high-power liquid-cooled systems. For example, physically grouping dedicated supply nozzles 126 and return nozzles 128 with associated outlets 110 may provide an intuitive and unambiguous arrangement of the various components associated with each outlet 110 (e.g., each connected load 102). Such an arrangement may provide ease of use during setup and/or maintenance by mitigating potential confusion. Such a configuration may provide efficient use of space within a rack by avoiding long coolant lines and/or preventing tangling of power and coolant lines. As another example, physically grouping dedicated supply nozzles 126 and return nozzles 128 with associated outlets 110 may enable the generation of differentiated load diagnostic data for loads 102 connected to each outlet 110, which may be used for load operational condition classification as described herein.

In examples, the LC sub-system 106 additionally provides cooling of the power distribution sub-system 104 (or portions thereof), which may mitigate overheating of the power distribution sub-system 104 and thus promote reliable operation. For example, portions of the LC sub-system 106 may be thermally coupled to portions of the power distribution sub-system 104.

As an illustration, FIG. 1B depicts placement of the circuit breakers 112 near (or connected to) the supply nozzle 126 (e.g., a cold side) for active thermal cooling. However, this is merely illustrative and should not be interpreted as limiting on the scope of the present disclosure. In some cases, circuit breakers 112 or other components of the power distribution sub-system 104 may be placed near (or connected to) the return nozzle 128 (e.g., a warm side). Such a configuration may be suitable for, but not limited to, applications where the temperature difference (Δ*T*) between the return fluid and the power distribution sub-system 104 is sufficient to cool the power distribution sub-system 104.

Further, in some examples, both the cold side and the warm side of the LC sub-system 106 may be thermally coupled to different portions of the power distribution sub-system 104 and/or to different power distribution sub-systems 104.

FIG. 1B further depicts a configuration in which the LC sub-system 106 and the power distribution sub-system 104 are in separate housings that are thermally coupled. For example, the LC sub-system 106 may be located in an LC housing 140, and the power distribution sub-system 104 may be located in a power housing 142 physically attached to the LC housing 140. In some examples, the power distribution system 100 includes a thermal interface material (TIM) 144 between the LC housing 140 and the power housing 142. Any suitable TIM may be used including, but not limited to, a thermal paste, a thermal pad, or a phase-change material (PCM). In some examples, the LC housing 140 and the power housing 142 have thermally conductive portions (e.g., metallic portions) that are secured together with bolts or any other suitable fastening mechanism.

The LC housing 140 and the power housing 142 may further have any shape or design. In some examples, the LC housing 140 and the power housing 142 have complementary shapes to promote contact and high thermal coupling. For example, the LC housing 140 and the power housing 142 may each have at least one flat side (e.g., as depicted in FIG. 1B) providing a continuous contact interface. As another example, the LC housing 140 and the power housing 142 may each have sides with complementary curved shapes to provide a continuous contact interface. As another example, the LC housing 140 and the power housing 142 may be joined using a thermally conductive mount or interface material. Such a configuration may be suitable for, but is not limited to, configurations in which the LC housing 140 and the power housing 142 have thermally-incompatible shapes and/or materials. As another example, the LC housing 140 and the power housing 142 are joined using a hinged mechanism. Such a configuration may allow for access to a contact interface and thus may enable selection, modification, or replacement of the TIM. For example, access to a contact point and/or a thermal interface material between the LC housing 140 and the power housing 142 may be provided through rotation of one or both of these housings.

It is contemplated herein that configurations providing separate housings for the LC sub-system 106 and the power distribution sub-system 104 may allow for the use of commercially available components and/or may naturally mitigate risk of electrical shortages caused by fluid leakage through compartmentalization of these components. Further, although FIG. 1B depicts the supply nozzle 126 and the return nozzle 128 on a common face as the outlets 110, this is merely an illustration and should not be interpreted as a limitation on the scope of the present disclosure. In some examples, the supply nozzle 126 and the return nozzle 128 may be located on a different face than a corresponding outlet 110 to mitigate a risk of electrical shortage due to fluid leakage while maintaining thermal contact between the LC sub-system 106 and the power distribution sub-system 104.

In some examples, although not explicitly shown, the LC sub-system 106 and the power distribution sub-system 104 may share a common housing. Such a configuration may beneficially allow for greater thermal coupling and thus more active cooling of the power distribution sub-system 104. Further, it is noted that while packaging liquid cooling components and electrical components into a common housing may provide some risk of electrical shortages in the present of fluid leakages, it is contemplated herein that components of the LC sub-system 106 may be fabricated with high tolerances such that the risks may be negligible or at least acceptable for certain applications. As an illustration, components for cold-plate cooling of a load 102 (e.g., a GPU, a CPU, or the like) typically also require close proximity of cooling fluid and sensitive components.

The LC sub-system 106 and/or the power distribution sub-system 104 may further include various additional components suitable for promoting heat transfer. For example, one or more housings of the LC sub-system 106 and/or the power distribution sub-system 104 may include fins to promote radiative heat transfer. As another example, one or more housings of the LC sub-system 106 and/or the power distribution sub-system 104 may include surface enhancements on internal and/or external surfaces to promote radiative heat transfer. For instance, surface enhancement may include, but are not limited to, painted surfaces, anodized surfaces, or structured surfaces. As an illustration, parts adjoining a cool side external surface of the LC housing 140 may include surface enhancements to improve heat transfer relative to a non-enhanced material. As another illustration, internal and/or external surfaces of the power housing 142 may include any elements suitable for improving natural convective heat transfer relative to a non-enhanced material such as, but not limited to, perforated ventilation, heat sinks, cavities, or chambers.

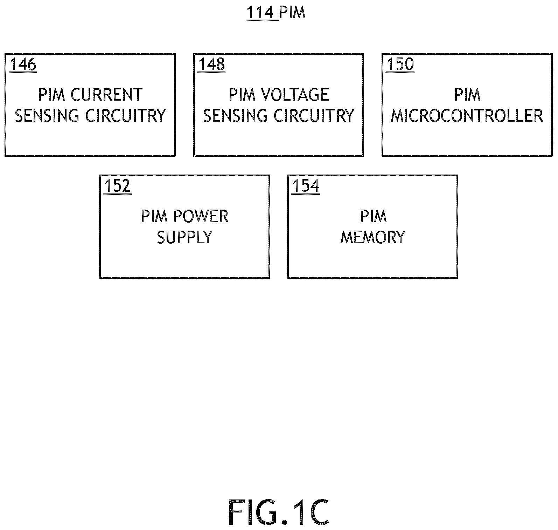

Referring now to FIGS. 1C-1E, additional aspects of the power distribution sub-system 104 are described in greater detail, in accordance with one or more examples of the present disclosure.

FIG. 1C is a block diagram view of a PIM 114, in accordance with one or more examples of the present disclosure. The PIM 114 may generate various measurements of the input power 108 including, but not limited to, input voltages and input currents and may further calculate energy metering data thereof. For example, the PIM 114 may include PIM current sensing circuitry 146 and/or PIM voltage sensing circuitry 148. The PIM 114 may also include one or more PIM microcontrollers 150, a PIM power supply 152, and a PIM memory 154. The PIM memory 154 may be embedded memory (e.g., internal memory) and/or external memory.

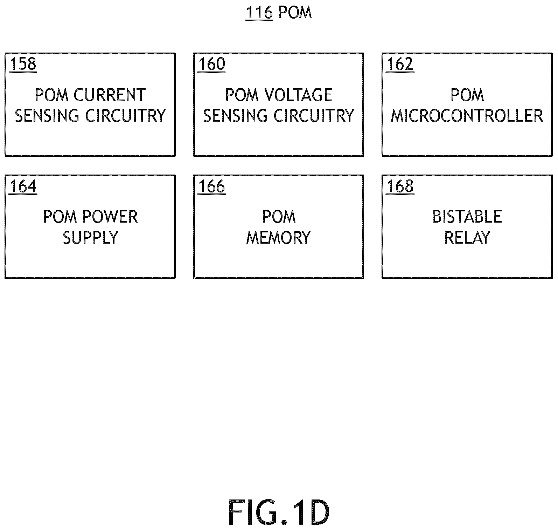

FIG. 1D is a block diagram view of a POM 116, in accordance with one or more examples of the present disclosure. The POM 116 may generate various measurements of load signals 156 (see FIG. 1A) associated with power transfer to the loads 102 through the outlets 110 including, but not limited to, load voltages and load currents and may further calculate energy metering data thereof. For example, the POM 116 may include POM current sensing circuitry 158 and/or POM voltage sensing circuitry 160. The POM 116 may also include one or more POM microcontrollers 162, a POM power supply 164, and a POM memory 166. The POM memory 166 may be embedded memory (e.g., internal memory) and/or external memory. The POM 116 may further control bistable relays 168 to selectively provide power (or not provide power) to each of the outlets 110.

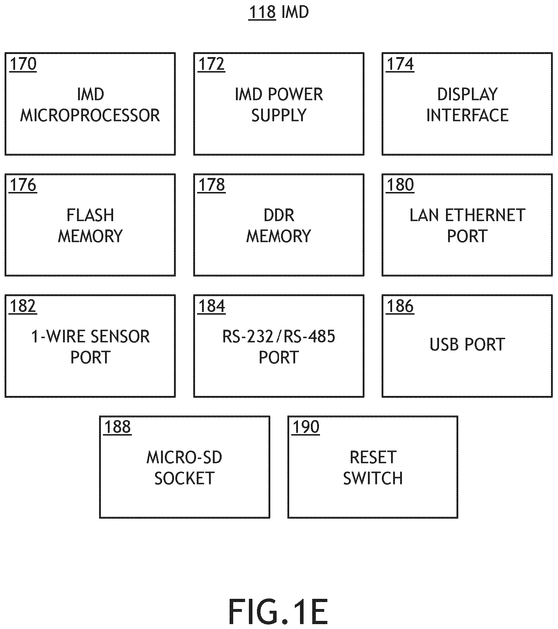

FIG. 1E is a block diagram view of an IMD 118, in accordance with one or more examples of the present disclosure. The IMD 118 may include, but is not limited to, one or more IMD microprocessors 170, an IMD power supply 172, a display interface 174 (which may be the same as or different than the visual display devices 120 illustrated in FIG. 1A), or a non-volatile (NV) memory in the form of flash memory 176 and/or DDR memory 178, which may be embedded or external. The IMD 118 may also include a plurality of ports including, but not limited to, one or more LAN Ethernet ports 180, one or more 1-wire sensor ports 182, an RS-232/RS-485 port 184, a USB port 186, or a microSD socket 188. The IMD may be coupled to a reset switch 190 for enabling a user to initiate a hard reset to the IMD 118, the power distribution system 100 and/or other subsystems within the power distribution system 100. The IMD 118 may also communicate with other componentry via an RS-485 physical layer. In some examples, the IMD 118 is provided as a hot-swappable web card in the power distribution system 100.

The IMD 118 may serve as the monitoring host controller for the power distribution system 100 and may be in constant communication with the POM 116. By communicating with the POM 116, the IMD 118 may provide a means for a user to enable or disable one or more features of the power distribution system 100, as well as acquire and display status information.

In examples, the IMD 118, the PIM 114, the POM 116, and/or the LC sub-system 106 are communicatively coupled (e.g., via one or more communication buses). In this way, each may command, send data to, and/or receive data from any of the others. For example, the IMD 118 may command the PIM 114, which may in turn command the POM 116 to configure the relay state of one or more of the bistable relays 168. As another example, the IMD 118 may act as a bus master, connected to both the PIM 114 and the POM 116, with the PIM 114 and the POM 116 not directly interacting with each other. As another example, the PIM 114 and/or the POM 116 is capable of autonomous behavior without commands from the IMD 118. As another example, the LC sub-system 106 may be communicatively coupled with any of the IMD 118, the POM 116, or the PIM 114 to send and/or receive data. For instance, the IMD 118 may receive at least some load diagnostic data from any of the LC sub-system 106 or the POM 116.

Referring generally to FIGS. 1A-1E, it is to be understood that FIGS. 1A-1E and the associated descriptions are provided merely for illustrative purposes and should not be interpreted as limiting. For example, although FIGS. 1A-1E presents the IMD 118, the POM 116, and the PIM 114 of the power distribution system 100 as separate components, this is merely an illustration and should not be interpreted to limit the scope of the present disclosure. In some examples, any of the IMD 118, the POM 116, or the PIM 114 may be integrated together in a common housing or as a common component. Further, the IMD 118, the POM 116, and/or the PIM 114 may generally include any type of processors known in the art including, but not limited to, a microprocessor, a microcontroller, a field-programmable gate array (FPGA), an application-specific integrated circuit (ASIC), a digital signal processor (DSP), a CPU, or a GPU. The IMD 118, the POM 116, and/or the PIM 114 may also include any type of memory (e.g., a non-transitory medium) including, but not limited to, a read-only memory, a random-access memory, a solid-state drive, or the like. Further, such memory may be embedded or external. In this way, the power distribution system 100 as a whole may utilize any combination of embedded and external memory. Some examples of a power distribution system 100 are generally described in United States Patent Application Serial Number 18/198,504 entitled "OUTLET IN-RUSH CURRENT LIMITER FOR INTELLIGENT POWER STRIP" filed on May 17, 2023 by Kevin Ferguson, Casey Gilson, Scott Cooper, and Jason Armstrong. As a result, any of the IMD 118, the PIM 114, or one or more POMs 116 may execute program instructions (or subsets of program instructions) alone or in combination to implement various process steps disclosed herein. As another example, the power distribution system 100 may have any combination of controllers and does not require at least one of a PIM 114, a POM 116, or an IMD 118 as depicted in FIGS. 1A-1E.

In some examples, various process steps, combinations of process steps, or portions of process steps are distributed between different components of the power distribution system 100. Such a configuration may provide efficient use of computational resources and/or minimize cost. Further, the IMD 118, the POM 116, and/or the PIM 114 may have different architectures to provide efficient distribution of computing power for different tasks and further manage costs of the power distribution system 100 as a whole. For example, the POMs 116 may have relatively simpler architecture than the IMD 118. As an illustration, the POM 116 may include microcontrollers and/or math accelerators suitable for receiving data and performing computational tasks on the data, whereas the IMD 118 may include more advanced processing units such as, but not limited to, a DSP, a microprocessor, a GPU, a faster CPU, or the like. In this way, the IMD 118 may perform more computationally intensive tasks, interface with a user, interface with additional equipment, or the like.

As an illustration, each POM 116 may generate or receive load diagnostic data associated with the loads 102 and/or classify any of the loads 102 based on the load diagnostic data. Each POM 116 may then send the results of the classification and/or the underlying load diagnostic data to the IMD 118. The IMD 118 may then provide further processing and/or communication with external systems (e.g., servers, other power distribution systems (e.g., PDUs), or the like). For example, the IMD 118 may manage and collect data from multiple POMs 116 and/or direct actions based on data from any of the POMs 116. As another example, the IMD 118 may receive user commands and/or instructions and may direct components such as the PIM 114 or the POMs 116 in compliance with such instructions. As another example, the IMD 118 may provide the POMs 116 with instructions and/or executable operations suitable for classifying load signals 156 based on load diagnostic data. For instance, the IMD 118 may train a machine learning model based on load diagnostic data from any of the POMs 116, the LC sub-system 106, and/or external sources and then provide the trained machine learning model to the POMs 116 for implementation. As another example, the IMD 118 may receive a trained machine learning model and provide this trained machine learning model to the POMs 116 for implementation. In this way, a machine learning model may generally be trained by any internal or external component of the power distribution system 100.

FIG. 2 is a flow diagram illustrating steps performed in a method 200 for classifying loads 102, in accordance with one or more examples of the present disclosure. The examples and enabling technologies described previously herein in the context of the power distribution system 100 should be interpreted to extend to the method 200. For example, an IMD 118, a PIM 114, and/or a POM 116 may execute program instructions causing associated processors to implement (or direct the implementation of) any of the process steps of the method 200 or portions thereof individually or in combination. It is further noted, however, that the method 200 is not limited to the architecture of the power distribution system 100. In this way, the various process steps of the method 200 may be implemented using any number or type of components.

In examples, the method 200 includes a process step 202 of capturing load diagnostic data for loads 102 (e.g., for any loads 102 connected to any of the outlets 110).

The load diagnostic data may generally include any data that may be indicative of or influenced by an operational condition of a load 102. For example, the load diagnostic data may include temperature data such as, but not limited to, a temperature of a load 102, an ambient temperature surrounding a load 102, a temperature of fluid exiting a respective supply nozzle 126, a temperature of fluid entering a respective return nozzle 128, or ambient conditions (e.g., temperature, humidity, moisture, or the like) of the power distribution system 100 (e.g., in or around one or more housings of the power distribution system 100) and/or any of the loads 102. As another example, the load diagnostic data may include the load signals 156 (or data derived therefrom) associated with a power connection. For instance, the load diagnostic data may include instantaneous or time series data or root-mean-square (RMS) values of the current and/or voltage data (e.g., a current and/or voltage drawn from any of the loads 102) associated with the load signals 156 between the loads 102 and associated outlets 110. As another example, the load diagnostic data may include utilization data associated with a load 102 (e.g., utilization data of at least one of a CPU or a GPU of a load 102).

The load diagnostic data may be generated by any combination of components associated with the power distribution system 100 or external to the power distribution system 100. For example, load diagnostic data may be captured by environmental sensors 136, a POM 116, a PIM 114, or provided to the power distribution system 100 via the data ports 138.

In examples, the method 200 includes a process step 204 of classifying the loads 102 into two or more classes based on the load diagnostic data. For example, the two or more classes include one or more normal classes associated with one or more acceptable operational conditions and one or more atypical classes associated with one or more atypical operational conditions.

In some examples, loads 102 are classified using a binary-class classification system including a single normal class and a single atypical class. Such a configuration may be well suited for, but not limited to, characterizing loads 102 of a single type, where an alert of atypical behavior is desired. In some examples, loads 102 are classified using a multi-class classification system including a single normal class and multiple atypical classes. Such a configuration may be well suited for, but not limited to, discriminating between different atypical classes. For instance, different atypical classes may be associated with different failure mechanisms and/or different pre-failure conditions such as, but not limited to, a cold plate malfunction, manifold scaling, or a power malfunction.

Referring again to FIG. 2, in some examples, the step 204 of classifying the loads 102 into two or more classes based on the load diagnostic data includes classifying the loads 102 into two or more classes using a machine learning model that accepts the load diagnostic data as inputs.

The machine learning model may utilize any type of learning or combination of learning types including, but not limited to, supervised learning, unsupervised learning, or reinforcement learning. Further, any type or structure of a machine learning model known in the art may be utilized in step 204 such as, but not limited to, a support vector machine classifier, a nearest neighbor classifier, a perceptron, a logistic regression classifier, or a Bayes classifier.

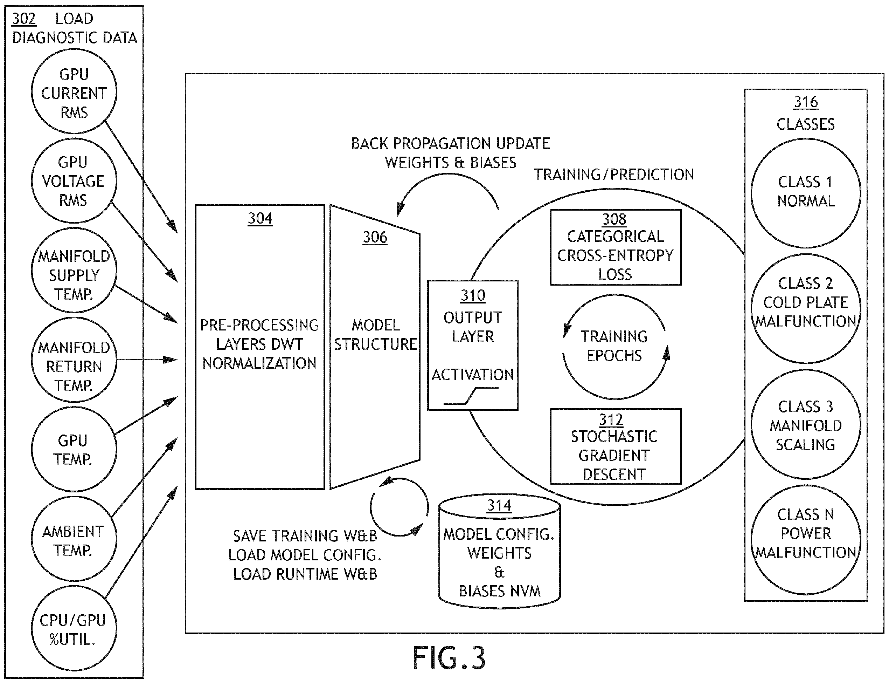

FIG. 3 is a flow diagram depicting classification using a machine learning model, in accordance with one or more examples of the present disclosure.

As depicted in FIG. 3, various load diagnostic data 302 may be pre-processed (block 304) into a form suitable for use with a machine learning model structure 306. For example, the machine learning model structure 306 may include, but is not limited to, a multi-layer perceptron (MLP), a convolutional neural network (CNN), or the like.

The pre-processing step (block 304) may include any process step suitable for providing the load diagnostic data 302 (or a portion thereof) into a form suitable for use with the machine learning model structure 306. For example, the load diagnostic data 302 may be provided in the form of a tensor. As another example, the load diagnostic data 302 may be normalized.

The machine learning model structure 306 may then be trained using any number of training epochs using a loss function 308, optimization function 310, and activation function 312. Any suitable loss function 308 may be utilized such as, but not limited to, a binary cross-entropy loss function or a hinge loss function. Any suitable optimization function 310 may be utilized such as, but not limited to, a gradient descent function (e.g., a stochastic gradient descent function, or the like). Any suitable activation function 312 may be utilized such as, but not limited to, a tanh for hidden layers, a sigmoid function (e.g., for binary-class classification) or a softmax function (e.g., for multi-class classification) for an output layer.

The model configurations, weights, and biases may be stored in memory 314 and updated through the training process.

Training data may generally include labeled load diagnostic data associated with the two or more classes along with other labeled inputs (e.g., load diagnostic data associated with known classes). The training data may further be provided through any source. For example, training data may be synthetically generated either locally or remotely. As another example, training data may be associated with historical load diagnostic data with known classes, which may be generated locally or received from a remote source (e.g., a data lake, or the like).

Once trained, the machine learning model structure 306 may be used to classify a load 102 based on associated load diagnostic data 302 into one of any number of classes 316 (e.g., prediction labels). In some examples, the machine learning model structure 306 provides a probability that a particular load 102 belongs to each class. In this way, the class having the highest probability may correspond to the assigned class.

It is noted FIG. 3 depicts a non-limiting configuration implementing multi-class classification. For example, FIG. 3 depicts classification of loads 102 into four classes 316 including a first class associated with normal operating conditions and three atypical classes. In particular, the atypical classes include a second class associated with a cold plate malfunction, a third class associated with scaling of a manifold 124, and a fourth class associated with a power malfunction. As another example, FIG. 3 depicts classification based on load diagnostic data 302 including a GPU current RMS value, a GPU voltage RMS value, a manifold 124 supply temperature, a manifold 124 return temperature, a GPU temperature, an ambient temperature, and CPU/GPU utilization percentages. It is noted herein that FIG. 3 and the associated description are provided merely for illustrative purposes and should not be interpreted as limiting on the scope of the present disclosure. For instance, any combination of load diagnostic data 302, number of classes 316, or the type of classes 316 are within the scope of the present disclosure.

It is further contemplated herein that practical implementation of a machine learning model such as, but not limited to, that depicted in FIG. 3 may be computationally intensive. As a result, it may be desirable to distribute various tasks between different computational elements to balance throughput and system cost.

In some examples, a power distribution system 100 as depicted in FIGS. 1A-3 may distribute various implementation aspects between different hardware components.

For example, the IMD 118 may perform the computationally intensive task of training a machine learning model and then send the trained model to the POMs 116. As an illustration, the IMD 118 may compute weights and biases, activation per layer for forward propagation, and optimization/loss for back propagation. This data, along with the structure of the machine learning model may then be sent to the POMs 116. Each POM 116 may then classify loads 102 based on the load diagnostic using the trained machine learning model.

As another example, the IMD 118 may receive a trained machine learning model and then send the trained model to the POMs 116. In this way, the machine learning model may be trained by an external system, which may substantially reduce computational requirements of the power distribution system 100.

The IMD 118 may further provide additional tasks such as, but not limited to, logging, communication to external sources (e.g., a data lake) for training and/or archival purposes, commanding the POMs 116 (or other components) to capture data at selected times for training and/or classification, or selecting a particular machine learning model for implementation (e.g., selecting a binary-class model, a multi-class model, or the like).

Referring again to FIG. 2, the method 200 may further include a process step 206 of generating one or more alert signals. For example, alert signals may be generated based on the classified load signals 156 when one or more alert conditions are met. Any alert condition may be utilized such as, but not limited to, when a load signal 156 is classified into one of the one or more atypical conditions.

The alert signals may further trigger any action. For example, an alert signal may trigger the automatic disconnection of an associated load 102. As another example, the alert signal may trigger at least one of a visual indicator (e.g., via one or more visual display devices 120) or an audio indicator (e.g., via one or more speakers 122). In this way, any combination of visual or audio text, speech, graphics, or other indicators may be provided to a user. As an illustration, alert signals may trigger visual and/or audio indications that one or more loads 102 may need to be disconnected, repaired, or receive maintenance. As another example, the alert signal may trigger a remote indicator using any selected protocol such as, but not limited to, email, simple network management protocol (SNMP), modbus, or an application programming interface (API) of a selected service.

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected" or "coupled" to each other to achieve the desired functionality, and any two components capable of being so associated can also be viewed as being "couplable" to each other to achieve the desired functionality. Specific examples of couplable include but are not limited to physically interactable and/or physically interacting components and/or wirelessly interactable and/or wirelessly interacting components and/or logically interactable and/or logically interacting components.

Further examples are set out in the clauses below:
1. A power distribution system comprising:
   a power distribution sub-system including power distribution circuitry configured to provide power from an input source to a plurality of loads through a plurality of outlets, wherein each of the plurality of outlets is configured to provide an electrical connection to any connected one of the plurality of loads;
   a liquid cooling sub-system configured to provide active cooling to at least some of the plurality of loads, wherein the liquid cooling sub-system includes one or more manifolds providing one or more supply nozzles and one or more return nozzles for directing fluid for the active cooling; and
   one or more housings configured to at least partially enclose the power distribution sub-system and the liquid cooling sub-system, wherein the one or more housings further provide thermal coupling between the power distribution sub-system and the liquid cooling sub-system for at least partial cooling of at least a portion of the power distribution sub-system.
2. The power distribution system of clause 1, wherein the one or more housings comprise a single housing to at least partially enclose the power distribution sub-system and the liquid cooling sub-system.
3. The power distribution system of clause 1, wherein the one or more housings comprise:
   a first housing to at least partially enclose the liquid cooling sub-system; and
   a second housing to at least partially enclose the power distribution sub-system, wherein the first housing and the second housing are thermally coupled.
4. The power distribution system of clause 3, further comprising one or more hinges to provide access to a thermal interface material providing the thermal coupling through rotation of at least of the first housing or the second housing.
5. The power distribution system of any one of the preceding clauses, further comprising:
   one or more controllers, wherein each of the plurality of outlets is coupled to at least one of the one or more controllers, wherein a respective one of the one or more controllers includes one or more processors configured to execute program instructions stored on a memory device, wherein the program instructions are configured to cause the one or more processors to:
   receive load diagnostic data for any loads connected to any of the plurality of outlets; and
   classify the plurality of loads connected to at least one of the plurality of outlets into two or more classes based on the load diagnostic data.
6. The power distribution system of clause 5, wherein the load diagnostic data for a respective load of the plurality of loads includes at least one of a temperature of the respective load, a temperature of fluid exiting a respective supply nozzle of the one or more supply nozzles, a temperature of fluid exiting any of the one or more manifolds, a temperature of fluid entering a respective return nozzle of the one or more return nozzles, a temperature of fluid exiting any of the one or more manifolds, an ambient temperature of the power distribution system, an ambient temperature of the respective load, a die temperature associated with a processor of the respective load, utilization data of at least one of a central processing unit or a graphical processing unit of the respective load, current drawn by the respective load or a voltage drawn by the respective load.
7. The power distribution system of clause 5 or 6, wherein the two or more classes include one or more normal classes associated with one or more acceptable operational conditions, wherein the two or more classes further include one or more atypical classes associated with one or more atypical operational conditions.
8. The power distribution system of clause 7, wherein the two or more classes comprise a binary set of classes, wherein the one or more normal classes include a single normal class, wherein the one or more atypical classes include a single atypical class.
9. The power distribution system of clause 7, wherein the two or more classes comprise:
   two or more sets of classes, wherein each of the two or more sets of classes corresponds to a different load type, wherein each of the two or more sets of classes includes at least one of the one or more normal classes and at least one of the one or more atypical classes.
10. The power distribution system of clause 7, wherein the one or more controllers are further configured to execute a subset of the program instructions causing the one or more controllers to generate one or more alert signals when at least one of the plurality of loads is classified as one of the one or more atypical classes.
11. The power distribution system of clause 7, wherein the one or more controllers are further configured to execute a subset of the program instructions causing the one or more controllers to disconnect power to at least one of the plurality of loads when classified as one of the one or more atypical classes.
12. The power distribution system of clause 5, wherein the one or more controllers comprise:
   one or more first controllers configured to be communicatively coupled to the plurality of outlets, wherein the one or more first controllers are configured to execute a subset of the program instructions causing the one or more first controllers to classify the plurality of loads into the two or more classes using a machine learning model; and
   one or more second controllers configured to be communicatively coupled with the one or more first controllers, wherein the one or more second controllers are configured to execute a subset of the program instructions causing the one or more second controllers to train the machine learning model using training data including labeled load diagnostic data associated with the two or more classes.
13. The power distribution system of clause 12, wherein the one or more first controllers and the one or more second controllers are located within the one or more housings.
14. The power distribution system of clause 12, wherein at least one of the one or more first controllers or the one or more second controllers are located external to the one or more housings.
15. The power distribution system of any one of clauses 12-14, wherein the one or more first controllers comprise one or more power output modules (POMs), wherein the one or more second controllers comprise one or more interchangeable monitoring devices (IMDs).
16. The power distribution system of any one of clauses 12-15, wherein the one or more first controllers utilize embedded memory, wherein the one or more second controllers utilize external memory.
17. The power distribution system of any one of clauses 12-16, wherein at least some of the labeled load diagnostic data is associated with historical load diagnostic data.
18. The power distribution system of clause 17, wherein historical load diagnostic data is provided by by at least one of the power distribution system, one or more additional power distribution systems, known historical failures of the plurality of loads, or a data lake.
19. The power distribution system of any one of clauses 5-18, wherein the one or more controllers are further configured to execute a subset of the program instructions causing the one or more controllers to display information associated with at least one of the plurality of loads on a display device based on an associated classification based on the load diagnostic data.
19a. A power distribution method comprising:
   providing, by power distribution circuitry of a power distribution sub-system, power from an input source to a plurality of loads through a plurality of outlets, wherein each of the plurality of outlets is configured to provide an electrical connection to any connected one of the plurality of loads;
   providing, by a liquid cooling sub-system, active cooling to at least some of the plurality of loads, wherein the liquid cooling sub-system includes one or more manifolds providing one or more supply nozzles and one or more return nozzles for directing fluid for the active cooling; and
   enclosing at least partially, by one or more housings, the power distribution sub-system and the liquid cooling sub-system, wherein the one or more housings further provide thermal coupling between the power distribution sub-system and the liquid cooling sub-system for at least partial cooling of at least a portion of the power distribution sub-system.
20. A power distribution method comprising:
   capturing, with a power distribution system, load diagnostic data for a plurality of loads connected to a plurality of outlets to receive power from an input power source connected to the plurality of outlets, wherein the power distribution system includes a liquid cooling sub-system configured to provide active cooling to at least some of the plurality of loads, wherein the liquid cooling sub-system includes one or more manifolds providing one or more supply nozzles and one or more return nozzles for directing fluid for the active cooling;
   classifying the plurality of loads connected to at least one of the plurality of outlets into two or more classes based on the load diagnostic data, wherein the two or more classes include one or more normal classes associated with one or more acceptable operational conditions, wherein the two or more classes further include one or more atypical classes associated with one or more atypical operational conditions; and
   when a particular load of the plurality of loads is classified as one of the one or more atypical classes, performing at least one of:
      generating one or more alert signals; or
      disconnecting power to the particular load.
20a. A power distribution system comprising configured to carry out the method of clause 20.

It is believed that the present disclosure and many of its attendant advantages will be understood by the foregoing description, and it will be apparent that various changes may be made in the form, construction, and arrangement of the components without departing from the disclosed subject matter or without sacrificing all of its material advantages. The form described is merely explanatory, and it is the intention of the following claims to encompass and include such changes. Furthermore, it is to be understood that the invention is defined by the appended claims.

## Claims

1. A power distribution system comprising:
a power distribution sub-system including power distribution circuitry configured to provide power from an input source to a plurality of loads through a plurality of outlets, wherein each of the plurality of outlets is configured to provide an electrical connection to any connected one of the plurality of loads;
a liquid cooling sub-system configured to provide active cooling to at least some of the plurality of loads, wherein the liquid cooling sub-system includes one or more manifolds providing one or more supply nozzles and one or more return nozzles for directing fluid for the active cooling; and
one or more housings configured to at least partially enclose the power distribution sub-system and the liquid cooling sub-system, wherein the one or more housings further provide thermal coupling between the power distribution sub-system and the liquid cooling sub-system for at least partial cooling of at least a portion of the power distribution sub-system.

2. The power distribution system of claim 1, wherein the one or more housings comprise a single housing to at least partially enclose the power distribution sub-system and the liquid cooling sub-system.

3. The power distribution system of claim 1, wherein the one or more housings comprise:
a first housing to at least partially enclose the liquid cooling sub-system; and
a second housing to at least partially enclose the power distribution sub-system, wherein the first housing and the second housing are thermally coupled; and optionally further comprising one or more hinges to provide access to a thermal interface material providing the thermal coupling through rotation of at least of the first housing or the second housing.

4. The power distribution system of any one of the preceding claims, further comprising:
one or more controllers, wherein each of the plurality of outlets is coupled to at least one of the one or more controllers, wherein a respective one of the one or more controllers includes one or more processors configured to execute program instructions stored on a memory device, wherein the program instructions are configured to cause the one or more processors to:
receive load diagnostic data for any loads connected to any of the plurality of outlets; and
classify the plurality of loads connected to at least one of the plurality of
outlets into two or more classes based on the load diagnostic data; and optionally wherein the load diagnostic data for a respective load of the plurality of loads includes at least one of a temperature of the respective load, a temperature of fluid exiting a respective supply nozzle of the one or more supply nozzles, a temperature of fluid exiting any of the one or more manifolds, a temperature of fluid entering a respective return nozzle of the one or more return nozzles, a temperature of fluid exiting any of the one or more manifolds, an ambient temperature of the power distribution system, an ambient temperature of the respective load, a die temperature associated with a processor of the respective load, utilization data of at least one of a central processing unit or a graphical processing unit of the respective load, current drawn by the respective load or a voltage drawn by the respective load.

5. The power distribution system of claim 4, wherein the two or more classes include one or more normal classes associated with one or more acceptable operational conditions, wherein the two or more classes further include one or more atypical classes associated with one or more atypical operational conditions.

6. The power distribution system of claim 5, wherein the two or more classes comprise a binary set of classes, wherein the one or more normal classes include a single normal class, wherein the one or more atypical classes include a single atypical class; or optionally
wherein the two or more classes comprise:
two or more sets of classes, wherein each of the two or more sets of classes corresponds to a different load type, wherein each of the two or more sets of classes includes at least one of the one or more normal classes and at least one of the one or more atypical classes.

7. The power distribution system of any one of claims 5-6, wherein the one or more controllers are further configured to execute a subset of the program instructions causing the one or more controllers to generate one or more alert signals when at least one of the plurality of loads is classified as one of the one or more atypical classes.

8. The power distribution system of any one of claims 5-7, wherein the one or more controllers are further configured to execute a subset of the program instructions causing the one or more controllers to disconnect power to at least one of the plurality of loads when classified as one of the one or more atypical classes.

9. The power distribution system of claim 4, wherein the one or more controllers comprise:
one or more first controllers configured to be communicatively coupled to the plurality of outlets, wherein the one or more first controllers are configured to execute a subset of the program instructions causing the one or more first controllers to classify the plurality of loads into the two or more classes using a machine learning model; and
one or more second controllers configured to be communicatively coupled with the one or more first controllers, wherein the one or more second controllers are configured to execute a subset of the program instructions causing the one or more second controllers to train the machine learning model using training data including labeled load diagnostic data associated with the two or more classes.

10. The power distribution system of claim 9, wherein the one or more first controllers and the one or more second controllers are located within the one or more housings; or optionally
wherein at least one of the one or more first controllers or the one or more second controllers are located external to the one or more housings.

11. The power distribution system of any one of claims 9-10, wherein the one or more first controllers comprise one or more power output modules (POMs), wherein the one or more second controllers comprise one or more interchangeable monitoring devices (IMDs).

12. The power distribution system of any one of claims 4-11, wherein the one or more first controllers utilize embedded memory, wherein the one or more second controllers utilize external memory.

13. The power distribution system of any one of claims 9-12, wherein at least some of the labeled load diagnostic data is associated with historical load diagnostic data; and optionally
wherein historical load diagnostic data is provided by at least one of the power distribution system, one or more additional power distribution systems, known historical failures of the plurality of loads, or a data lake.

14. The power distribution system of any one of claims 4-13, wherein the one or more controllers are further configured to execute a subset of the program instructions causing the one or more controllers to display information associated with at least one of the plurality of loads on a display device based on an associated classification based on the load diagnostic data.

15. A power distribution method comprising:
capturing, with a power distribution system, load diagnostic data for a plurality of loads connected to a plurality of outlets to receive power from an input power source connected to the plurality of outlets, wherein the power distribution system includes a liquid cooling sub-system configured to provide active cooling to at least some of the plurality of loads, wherein the liquid cooling sub-system includes one or more manifolds providing one or more supply nozzles and one or more return nozzles for directing fluid for the active cooling;
classifying the plurality of loads connected to at least one of the plurality of outlets into two or more classes based on the load diagnostic data, wherein the two or more classes include one or more normal classes associated with one or more acceptable operational conditions, wherein the two or more classes further include one or more atypical classes associated with one or more atypical operational conditions; and
when a particular load of the plurality of loads is classified as one of the one or more atypical classes, performing at least one of:
generating one or more alert signals; or
disconnecting power to the particular load.
